# EUROPÄISCHE PATENTANMELDUNG

(11) **EP 4 576 577 A1**
(43) Veröffentlichungstag der Anmeldung: **25.06.2025**
(21) Anmeldenummer: 23219074.4
(22) Anmeldetag: 21.12.2023
(51) Int. Cl.: H03K 17/97, H01H 36/00, H03K 17/95

(54) **ANORDNUNG UMFASSEND EIN FUNKTIONSMODUL, EINE DOSE UND EIN KIPPHEBELSCHALTGERÄT**

(71) Anmelder: Insta GmbH, 58509 Lüdenscheid (DE); Albrecht Jung GmbH & Co. KG, 58579 Schalksmühle (DE)
(72) Erfinder: Era, Eduard, 58513 Lüdenscheid (DE); Stracke, Martin, 58762 Altena (DE)
(74) Vertreter: Fobbe, Tobias

(57) **Zusammenfassung**

Vorgestellt wird eine Anordnung umfassend ein Schaltgerät S, insbesondere ein Schalter oder ein Taster, eine Installationsdose D und ein Funktionsmodul F, welches Funktionsmodul F durch die Betätigung eines an dem Schaltgerät S angeschlossenen Betätigungselementes eines Oberteils O des Schaltgerätes S beeinflussbar ist, wobei das Funktionsmodul F zumindest eine Schnittstelle aufweist, mittels welcher zumindest ein Aktor entsprechend einer Betätigung des Betätigungselements ansteuerbar ist, wobei an dem Schaltgerät S mindestens ein Magnet angeordnet ist, welcher bei Betätigung des Betätigungselementes seine Position ändert, und wobei das Funktionsmodul F einen Sensor H zur Erfassung des Magnetfeldes MF aufweist, so dass die Änderung des Magnetfeldes MF bei Betätigung des Betätigungselementes detektiert wird, wobei das Funktionsmodul F eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät S handelt, welche Identifikation in die funktionsmodulseitige Ansteuerung des Aktors einfließt.

Besonders dabei ist, dass das Betätigungselement als ein um eine Achse schwenkbarer Kipphebel K ausgeführt ist, wobei der Kipphebel K den Magneten aufweist.

## Beschreibung

Die Erfindung betrifft eine Anordnung umfassend ein Schaltgerät, insbesondere ein Schalter oder ein Taster, eine Installationsdose und ein Funktionsmodul, welches Funktionsmodul durch die Betätigung eines an dem Schaltgerät angeschlossenen Betätigungselementes eines Oberteils des Schaltgerätes beeinflussbar ist, wobei das Funktionsmodul zumindest eine Schnittstelle aufweist, mittels welcher zumindest ein Aktor entsprechend einer Betätigung des Betätigungselements ansteuerbar ist, wobei an dem Schaltgerät mindestens ein Magnet angeordnet ist, welcher bei Betätigung des Betätigungselementes seine Position ändert, und wobei das Funktionsmodul einen Sensor zur Erfassung des Magnetfeldes aufweist, so dass die Änderung des Magnetfeldes bei Betätigung des Betätigungselementes detektiert wird, wobei das Funktionsmodul eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt.

Aus AT 525 242 B1 ist eine Anordnung umfassend ein Schaltgerät, insbesondere ein Schalter oder ein Taster, eine Installationsdose und ein Funktionsmodul, bekannt geworden. Ein solches Funktionsmodul ist durch die Betätigung eines an dem Schaltgerät angeschlossenen Betätigungselementes (einer Wippe) eines Oberteils des Schaltgerätes beeinflussbar, beispielsweise um Lampen zu schalten, zu dimmen oder um Jalousien zu steuern, und zwar auch fernbedienbar, beispielsweise via Endgerät. Hierzu weist das Funktionsmodul zumindest eine Schnittstelle auf, mittels welcher zumindest ein Aktor entsprechend einer Betätigung des Betätigungselements ansteuerbar ist, wobei an dem Schaltgerät - regelmäßig an der Wippe - mindestens ein Magnet angeordnet ist, welcher bei Betätigung des Betätigungselementes seine Position ändert. Ferner weist das Funktionsmodul einen Sensor zur Erfassung des Magnetfeldes auf, so dass die Änderung des Magnetfeldes bei Betätigung des Betätigungselementes detektiert wird. Es versteht sich, dass das Funktionsmodul über ein Endgerät, insbesondere ein mobiles Endgerät, beeinflussbar ist, um auf komfortable Weise bedient werden zu können. Ein solches, vorbekanntes Funktionsmodul umfasst zudem eine Auswerteeinheit zur Auswertung der Magnetfeldänderung, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt, so dass ein Austausch von Schaltern durch Taster vermieden wird. So erfordert das Dimmen einer Lampe mit einem Funktionsmodul beispielsweise eine spezifische Ansteuerung, je nachdem, ob das zugrundeliegende Schaltgerät ein Taster oder ein Schalter ist. Daher ist die Identifikation der Schaltgeräteart durch die Auswerteeinheit ein weiterer Vorteil eines solchen Funktionsmoduls.

Durch ein Funktionsmodul solcher vorbekannter Anordnungen kann der Installationsaufwand mit Blick auf den zu leistenden Verkabelungsaufwand wie er bei herkömmlichen Funktionsmodulen ohne Sensierung der Magnetfeldänderung erforderlich ist - hierbei werden Kabel zwischen Schaltgerät und Funktionsmodul (nachfolgend fliegende Verkabelung genannt) angeschlossen, um die Betätigung elektrisch zu übermitteln - signifikant verringert werden, da Funktionsmodul und Schaltgerät magnetisch miteinander kommunizieren; ein elektrischer Anschluss des Funktionsmoduls an das Schaltgerät mithin obsolet geworden ist. Vielmehr übernimmt der regelmäßig in der Wippe des Schalters- oder Tasters angeordnete Magnet die Aufgabe, die erfolgte Betätigung der Wippe in Gestalt einer Magnetfeldänderung an den Sensor des Funktionsmoduls zu übermitteln.

Problematisch bei solchen vorbekannten gattungsgemäßen Anordnungen ist jedoch, dass diese das Vorhandensein einer Betätigungswippe voraussetzen. Eine Betätigungswippe eröffnet durch das Vorhandensein einer Vorder- und einer Rückseite die Option, einen Magneten unsichtbar an der Rückseite der Betätigungswippe anzubringen. Zudem weist eine solche Wippe regelmäßig eine Fläche von über 60cm² je Vorder- und Rückseite auf, so dass ausreichend Bauraum zur Unterbringung eines Magneten zur Verfügung steht. Kipphebelschalter hingegen weisen intrinsisch nur wenige cm² Fläche (insbesondere weniger als 5 cm² Fläche) auf, so dass diese im Stand der Technik aus Bauraumgründen nicht im Zusammenhang mit einer gattungsgemäßen Anordnung auch nur ansatzweise offenbart beziehungsweise realisiert sind.

Ausgehend von diesem diskutierten Stand der Technik liegt der Erfindung die Aufgabe zugrunde, eine installationsaufwandsminimierte Anordnung umfassend ein Schaltgerät, eine Installationsdose und ein Funktionsmodul, zu schaffen, wobei die Anordnung ein Kipphebelschaltgerät als Schaltgerät, das bezüglich Bauraum und Unauffälligkeit deutlich anspruchsvoller als Wipp-Schalt- oder Tastgeräte ist, umfasst.

Gelöst wird diese Aufgabe durch eine Anordnung umfassend ein Schaltgerät, eine Installationsdose und ein Funktionsmodul, wobei das Betätigungselement als ein um eine Achse schwenkbarer Kipphebel ausgeführt ist, wobei der Kipphebel den Magneten aufweist.

Damit wird erfindungsgemäß erreicht, dass auch Kipphebelschaltgeräte, wobei das Betätigungselement als ein um eine Achse schwenkbarer Kipphebel ausgeführt ist, im Rahmen der erfindungsgemäßen Anordnung mit einer Installationsdose, einem Funktionsmodul und dem Kipphebelschaltgerät realisiert werden können, obwohl gerade kein Schaltgerät mit einer Wippe (die regelmäßig eine Fläche von über 60cm² je Vorder- und Rückseite zur Unterbringung eines Magneten zur Verfügung) vorhanden ist.

Dabei wir auf geschickte Art und Weise der Magnet an dem Kipphebel angeordnet, so dass dieser - wenn er sich in Folge einer Betätigung bewegt -, eine Magnetfeldänderung verursacht, die durch den Sensor zur Erfassung des Magnetfeldes im Funktionsmodul erfasst wird. Dabei geht vorteilhafterweise die radiale Erstreckung des Kipphebels bezüglich seiner Schwenkachse beziehungsweise des Magneten (im Gegensatz zur eher tangentialen Erstreckung einer Wippe bezüglich ihrer Schwenkachse) mit einem verhältnismäßig großen Abstand zwischen Magnet und Schwenkachse einher so, dass die Magnetfeldänderung trotz der geringen Änderung der Kipphebelposition besonders stark ausfällt, so dass das Signal-zu-Rausch-Verhältnis (trotz des höheren Abstandes eines Kipphebels im Vergleich einer Wippe zum Sensor) verbessert wird. Insofern wird durch die erfindungsgemäße Anordnung des Magneten an einem Kipphebel nicht nur das Anwendungsgebiet einer vorbekannten Anordnung von bauraumtechnisch (bezüglich der Unterbringung eines Magneten) wenig anspruchsvollen Wipp-Schaltgeräten auf Kipphebelschaltgeräte erweitert, sondern auch das Signal-zu-Rausch-Verhältnis und damit die Zuverlässigkeit der Detektion einer Betätigung weiter verbessert.

Gemäß einer außerordentlich bevorzugten Weiterbildung der erfindungsgemäßen Anordnung ist der Magnet als magnetische Hülse ausgeführt, die auf den Kipphebel aufsetzbar, beispielsweise aufstülpbar, ist. Eine solche Lösung geht mit dem besonders attraktiven Vorteil einher, dass das Aufsetzen der magnetischen Hülse auf den Kipphebel, insbesondere einen bereits im Bestand bestehenden Kipphebel, einerseits besonders einfach in der Montage ist und andererseits ein optisch besonders ansprechendes und einheitliches Bild entsteht. Darüber hinaus erlaubt es eine solche Hülse, nicht nur ein besonders großes Volumen für den Magneten bereitzustellen, sondern wertet sie optisch und haptisch einen bereits in Benutzung befindlichen Kipphebel auf, indem der alte - regelmäßig optisch und haptisch durch Benutzung und Umwelteinflüsse degradierte - Kipphebel durch die erfindungsgemäße magnetische Hülse effektiv abgedeckt wird. Insofern wird durch diese erfindungsgemäße Ausführungsform nicht nur auf intelligente Weise das Volumen für den Magneten maximiert und der Montageaufwand minimiert, sondern der symbiotische Effekt erreicht, dass die Hülse gleichzeitig einen optisch und haptisch gealterten Kipphebel optisch und haptisch spürbar im Rahmen einer Nachrüstung aufwertet. Damit stellt diese Ausführungsform die am meisten bevorzugte Ausführungsform im Rahmen der Erfindung dar.

In einer bevorzugten Weiterbildung dieser erfindungsgemäßen Anordnung ist weist die magnetische Hülse eine Wandstärke von weniger als 5mm auf. Hierdurch wird der optische Gesamteindruck nur marginal geändert. Gleichzeitig erlaubt eine solche Wandstärke ein mehr als ausreichendes Volumen für einen Magneten, um ein sehr gutes Signal-zu-Rausch-Verhältnis am Sensor zur Erfassung der durch die Betätigung des Kipphebels hervorgerufenen Magnetfeldänderung zu realisieren.

In einer weiteren Weiterbildung dieser erfindungsgemäßen Anordnung weist die magnetische Hülse mindestens eine seitliche Ausnehmung auf. Hierdurch wird die Passform der magnetischen Hülse, insbesondere die Formbarkeit, verbessert - beispielsweise durch die Ausbildung von Federschenkeln, die sich zum Aufsetzen auf den Kipphebel aufspreizen lassen und dann eine rückstellende Kraft zum Fixieren der magnetischen Hülse auf dem Kipphebel ausüben.

In einer weiteren Weiterbildung dieser erfindungsgemäßen Anordnung weist die magnetische Hülse auf ihrer Innenseite ein elastisches Element auf. Hierdurch wird nicht nur die Abzugskraft der magnetischen Hülse bezüglich des Kipphebels erhöht, sondern gleichzeitig die geometrische Toleranz bezüglich unterschiedlicher Kipphebelgeometrien erhöht.

In einer weiteren Weiterbildung dieser erfindungsgemäßen Anordnung ist die magnetische Hülse jedenfalls teilweise drehbar und/oder verschiebbar auf dem Kipphebel gelagert, so dass der Kipphebel um eine Drehfunktionalität beziehungsweise Schiebefunktionalität, beispielsweise zum Dimmen oder Verfahren einer Jalousie, weitergebildet wird. Damit für den Endanwender, sofern das Funktionsmodul als Dimmer oder Aktor zum Verfahren einer Jalousie weitergebildet ist, eine weitere Funktionalität auf den bestehenden Kipphebel gelegt. Die Weiterbildung des Kipphebels um eine Drehfunktionalität kann beispielsweise so sein, dass die Stirnseite des Kipphebels oder die Ober- oder Unterseite des Kipphebels (Oberseite weist zum Himmel, Unterseite weist zum Erdboden) ein magnetisches Drehelement und/oder ein Schiebeelement aufweisen.

Gemäß einer alternativen Weiterbildung der erfindungsgemäßen Anordnung ist der Magnet als aufklebbarer Magnet, insbesondere als magnetische Klebefolie, ausgeführt. Eine solche Lösung ist gleichermaßen unauffällig wie kostengünstig und daher ebenfalls als sehr vorteilhafte Ausführungsform anzusehen. Dabei ist in einer Ausführungsform der Magnet an der nach unten weisenden Seite des Kipphebels angeordnet. In Anbetracht der Tatsache, dass der Kipphebel regelmäßig in einer Höhe von ca. 1m über dem Fußboden angeordnet ist, ist ein an der nach unten (also zum Erdboden) weisenden Seite des Kipphebels angeordneter Magnet im Regelfall (stehende oder auf einem Stuhl sitzende Person mit einer Körpergröße von mehr als 1,6m) als effektiv unsichtbar anzusehen. Damit ist es im Vergleich zum Stand der Technik (Wippschalter, der eine Rückseite aufweist, die ohne weiteres ein Anbringen eines Magneten ermöglicht) auch bei der bauraumtechnisch deutlich beschränkteren Kategorie von Schaltgeräten, den Kippschaltgeräten, ermöglicht, eine kostengünstige und optisch unauffällige Lösung zu finden, die Betätigung des Betätigungselementes magnetisch zu detektieren. In einer weiteren alternativen Ausführungsform ist der Magnet an den Seiten des Kipphebels, die nicht nach unten oder oben weisen, angeordnet. Damit ist eine besonders dauerhafte und kostengünstige Anbringung des Magneten am Kipphebel möglich, da diese Seiten regelmäßig weniger durch einen Anwender bei der Betätigung des Kipphebels berührt werden.

Gemäß einer weiteren alternativen Weiterbildung der erfindungsgemäßen Anordnung ist der Magnet als Magnetlack, insbesondere aufgebracht durch einen Pinsel oder ein Spray, ausgeführt. Hierdurch wird erreicht, dass jedwede Geometrie eines Kipphebels nachträglich magnetisch gestaltet werden kann. Insofern ist diese Ausführungsform besonders flexibel einsetzbar.

Gemäß einer weiteren alternativen Weiterbildung der erfindungsgemäßen Anordnung umfasst der Kipphebel den Magnet, insbesondere ist der Kipphebel aus einem magnetischen Material, insbesondere monolithisch, gefertigt.

In einer weiteren alternativen Weiterbildung der erfindungsgemäßen Anordnung weist der Kipphebel von innen eine Aufnahme für den Magneten auf. Damit ist auf besonders vorteilhafte Weise ermöglicht, den Magneten unsichtbar anzuordnen.

In einer weiteren Weiterbildung der erfindungsgemäßen Anordnung umfasst der Magnet Neodym. Hierdurch werden besonders starke Magnetfelder erzeugt, so dass auch im besonderen Fall der verhältnismäßig kleinbauenden Kipphebel besonders hohe Signal-zu-Rausch-Verhältnisse erzeugt werden können.

Gemäß einer bevorzugten Weiterbildung der erfindungsgemäßen Anordnung weist das Funktionsmodul Ausnehmungen auf, die mit Vorsprüngen der Installationsdose, eine mechanische Wirkverbindung herstellend, in Eingriff gestellt sind. Hierdurch kann ein Verrutschen des Funktionsmoduls wirksam vermieden und durch das Schaffen einer Vorzugslage das Signal-zu-Rausch-Verhältnis optimiert werden.

Nachfolgend ist die Erfindung unter Bezugnahme auf die beigefügten Figuren anhand diverser Ausführungsbeispiele beschrieben. Es zeigen:
- **Fig. 1:**: eine schematische Seitenansicht einer erfindungsgemäßen Anordnung, umfassend ein Schaltgerät, ein Funktionsmodul und eine Installationsdose, wobei der Kipphebel einen aufklebbaren Magnet aufweist,
- **Fig. 2:**: eine schematische Seitenansicht einer weiteren erfindungsgemäßen Anordnung, wobei auf den Kipphebel eine magnetische Hülse aufgesetzt ist,
- **Fig. 3:**: eine schematische Seitenansicht einer weiteren erfindungsgemäßen Anordnung, wobei der Kipphebel um eine Drehfunktionalität weitergebildet ist,
- **Fig. 4:**: eine schematische Seitenansicht einer weiteren erfindungsgemäßen Anordnung, wobei der Kipphebel um eine Schiebefunktionalität weitergebildet ist, und
- **Fig. 5:**: eine schematische Seitenansicht einer weiteren erfindungsgemäßen Anordnung, wobei auf den Kipphebel ein magnetischer Lack aufgebracht ist, beispielsweise durch einen Pinsel oder ein Spray.

In den verschiedenen Figuren sind gleiche Teile stets mit den gleichen Bezugszeichen versehen und werden daher in der Regel auch jeweils nur einmal benannt beziehungsweise erwähnt.

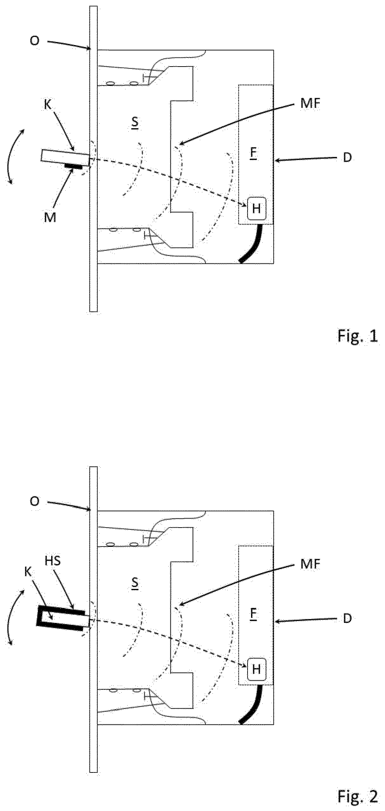

Die in Figur 1 schematisch in einer Seitenansicht dargestellte erfindungsgemäße Anordnung umfasst ein Schaltgerät S, ein Funktionsmodul F und eine Installationsdose D. Durch eine Betätigung eines an dem Schaltgerät S angeschlossenen Betätigungselementes eines Oberteils O des Schaltgerätes S, hier: ein Kipphebel K, ist das Schaltgerät S beeinflussbar, beispielsweise zum Schalten einer Lampe, indem der Sensor H zur Erfassung des Magnetfeldes MF die durch die Betätigung bedingte Änderung des Magnetfeldes MF erfasst. Dabei weist das Funktionsmodul F eine Auswerteeinheit zur Auswertung der Magnetfeldänderung auf, die dazu eingerichtet ist, in Abhängigkeit der sensierten Magnetfeldänderung zu identifizieren, um welche Schaltgeräteart es sich bei dem Schaltgerät S handelt, welche Identifikation in die funktionsmodulseitige Ansteuerung des Aktors einfließt. Ein Schaltgerät S kann beispielsweise ein Schalter oder ein Taster darstellen, wobei das Schaltgerät S einen Magneten, hier ausgebildet als magnetische Klebefolie M, am Kipphebel K aufweist. Diese magnetische Klebefolie M ist an der Unterseite des Kipphebels K angeordnet, so dass ein Anwender diese optisch regelmäßig nicht wahrnimmt. Vorteilhaft bei einem derartigen Funktionsmodul F ist, dass es keine Verkabelung des Funktionsmoduls F mit dem Schaltgerät S erfordert. Bei einer solchen erfindungsgemäßen Anordnung wird sich bevorzugt auf geschickte Art und Weise zu Nutze gemacht, dass zur Verbesserung der Zuverlässigkeit der Detektion einer Betätigung des Betätigungselements des Schaltgerätes S das Funktionsmodul F in der Installationsdose D fixierend gegenüber mechanischen Erschütterungen festgelegt ist. Eine solche fixierende Festlegung kann erfindungsgemäß beispielsweise durch einen zwischen Installationsdose D und Funktionsmodul F vermittelnden Klebstoff erreicht werden. Alternativ kann das Funktionsmodul F erfindungsgemäß auch Ausnehmungen (also keine konstante Höhe) aufweisen, die mit Vorsprüngen der Installationsdose D, insbesondere eine mechanische Wirkverbindung herstellend, in Eingriff gestellt sind. Hierdurch wird wertvolle Einbautiefe in der Installationsdose D eingespart und die Gefahr eines Verrutschens des Funktionsmoduls F in der Installationsdose D minimiert.

Die in Figur 2 schematisch in einer Seitenansicht dargestellte erfindungsgemäße Anordnung ist dadurch gekennzeichnet, dass auf den Kipphebel K eine magnetische Hülse HS aufgesetzt ist. Damit wird eine besonders einfache Montage erreicht, da die Hülse auf den Kippehebel K aufgesetzt wird. Zur Verbesserung der Abzugskraft, kann die Innenseite der magnetischen Hülse HS ein elastisches Material, beispielsweise ein Gummi, oder/und einen Klebstoff aufweisen. Besonders vorteilhaft bei einer erfindungsgemäßen magnetische Hülse HS, die auf den Kipphebel K aufgesetzt ist, ist zudem, dass hierdurch optisch und/oder haptisch degradierte im Bestand befindliche Kipphebel K im Zuge der Magnetisierung des Kipphebels K nachträglich aufgewertet werden können, so dass für den Endanwender unterschiedliche symbiotische Effekte bei einfachem Aufwand erreicht werden können, ohne neue Kipphebelschaltgeräte installieren zu müssen.

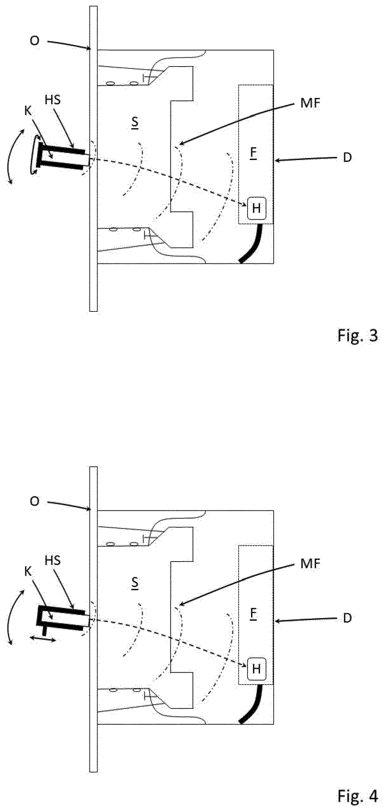

Die in Figur 3 schematisch in einer Seitenansicht dargestellte erfindungsgemäße Anordnung ist dadurch gekennzeichnet, dass der Kipphebel K um eine Drehfunktionalität weitergebildet ist. Dieses wird erreicht, indem die magnetische Hülse HS jedenfalls teilweise drehbar auf dem Kipphebel K gelagert ist, so dass der Kipphebel K um eine Drehfunktionalität, beispielsweise zum Dimmen oder Verfahren einer Jalousie, weitergebildet wird. Der Sensor H erkennt damit nicht nur eine Kippbewegung, beispielsweise zum Ein-/Ausschalten von Licht, sondern zudem eine Drehbewegung, beispielsweise zum Dimmen von Licht.

Die in Figur 4 schematisch in einer Seitenansicht dargestellte erfindungsgemäße Anordnung ist dadurch gekennzeichnet, dass der Kipphebel K um eine Schiebefunktionalität weitergebildet ist. Dieses wird erreicht, indem die magnetische Hülse HS jedenfalls teilweise verschieblich auf dem Kipphebel K gelagert ist, so dass der Kipphebel K um eine Schiebefunktionalität, beispielsweise zum Dimmen oder Verfahren einer Jalousie, weitergebildet wird. Der Sensor H erkennt damit nicht nur eine Kippbewegung, beispielsweise zum Ein-/Ausschalten von Licht, sondern zudem eine Schiebebewegung, beispielsweise zum Dimmen von Licht.

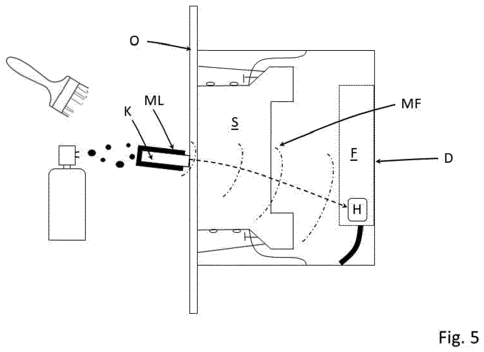

Die in Figur 5 schematisch in einer Seitenansicht dargestellte erfindungsgemäße Anordnung ist dadurch gekennzeichnet, dass auf den Kipphebel K ein magnetischer Lack ML aufgebracht ist, beispielsweise durch einen Pinsel oder ein Spray. Dieses stellt eine universelle Lösung dar, um den Kipphebel K mit einem Magneten auszustatten, insbesondere geeignet für unterschiedliche Kipphebelgeometrien.

### Bezugszeichenliste

- D: Installationsdose
- F: Funktionsmodul
- H: Sensor
- HS: Hülse
- K: Kipphebel
- M: magnetische Klebefolie
- MF: Magnetfeld
- ML: Magnetlack
- O: Oberteil
- S: Schaltgerät

## Patentansprüche

1. Anordnung umfassend ein Schaltgerät (S), insbesondere ein Schalter oder ein Taster, eine Installationsdose (D) und ein Funktionsmodul (F), welches Funktionsmodul (F) durch die Betätigung eines an dem Schaltgerät (S) angeschlossenen Betätigungselementes eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselements ansteuerbar ist, wobei an dem Schaltgerät (S) mindestens ein Magnet angeordnet ist, welcher bei Betätigung des Betätigungselementes seine Position ändert, und wobei das Funktionsmodul (F) einen Sensor (H) zur Erfassung des Magnetfeldes (MF) aufweist, so dass die Änderung des Magnetfeldes (MF) bei Betätigung des Betätigungselementes detektiert wird, wobei das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt, **dadurch gekennzeichnet, dass** das Betätigungselement als ein um eine Achse schwenkbarer Kipphebel (K) ausgeführt ist, wobei der Kipphebel (K) den Magneten aufweist.

2. Anordnung nach Anspruch 1, **dadurch gekennzeichnet, dass** der Magnet als magnetische Hülse (HS) ausgeführt ist, die auf den Kipphebel (K) aufsetzbar ist.

3. Anordnung nach Anspruch 2, **dadurch gekennzeichnet, dass** die magnetische Hülse (HS) eine Wandstärke von weniger als 5mm aufweist.

4. Anordnung nach Anspruch 2 oder 3, **dadurch gekennzeichnet, dass** die magnetische Hülse (HS) mindestens eine seitliche Ausnehmung aufweist.

5. Anordnung nach einem der Ansprüche 2 bis 4, **dadurch gekennzeichnet, dass** die Innenseite der magnetischen Hülse (HS) ein elastisches Material umfasst.

6. Anordnung nach einem der Ansprüche 2 bis 5, **dadurch gekennzeichnet, dass** die magnetische Hülse (HS) jedenfalls teilweise drehbar und/oder verschiebbar auf dem Kipphebel (K) gelagert ist, so dass der Kipphebel (K) um eine Drehfunktionalität beziehungsweise Schiebefunktionalität, beispielsweise zum Dimmen oder Verfahren einer Jalousie, weitergebildet wird.

7. Anordnung nach Anspruch 1, **dadurch gekennzeichnet, dass** der Magnet als aufklebbarer Magnet, insbesondere als magnetische Klebefolie (M), ausgeführt ist.

8. Anordnung nach Anspruch 7, **dadurch gekennzeichnet, dass** der Magnet an der nach unten weisenden Seite des Kipphebels (K) und/oder an den Seiten des Kipphebels (K), die nicht nach unten oder oben weisen, angeordnet ist.

9. Anordnung nach Anspruch 1, **dadurch gekennzeichnet, dass** der Magnet als Magnetlack (ML), insbesondere aufgebracht durch einen Pinsel oder ein Spray, ausgeführt ist.

10. Anordnung nach Anspruch 1, **dadurch gekennzeichnet, dass** der Kipphebel (K) den Magnet umfasst.

11. Anordnung nach Anspruch 1, **dadurch gekennzeichnet, dass** der Kipphebel (K) von innen eine Aufnahme für den Magneten umfasst.

12. Anordnung nach einem der Ansprüche 1 bis 11, **dadurch gekennzeichnet, dass** der Magnet Neodym umfasst.

13. Anordnung nach einem der Ansprüche 1 bis 12, **dadurch gekennzeichnet, dass** das Funktionsmodul (F) Ausnehmungen aufweist, die mit Vorsprüngen der Installationsdose (D), insbesondere eine mechanische Wirkverbindung herstellend, in Eingriff gestellt sind.
